(19) Europäisches Patentamt
European Patent Office
Office européen des brevets

(11) **EP 3 460 828 A1**

(12) **EUROPEAN PATENT APPLICATION**
published in accordance with Art. 153(4) EPC

(43) Date of publication:
**27.03.2019  Bulletin 2019/13**

(51) Int Cl.:
*H01L 21/027* *(2006.01)*          *B29C 33/38* *(2006.01)*
*B29C 59/04* *(2006.01)*          *C08F 2/44* *(2006.01)*
*C08F 220/18* *(2006.01)*          *C08F 290/06* *(2006.01)*

(21) Application number: **17799317.7**

(22) Date of filing: **15.05.2017**

(86) International application number:
**PCT/JP2017/018137**

(87) International publication number:
**WO 2017/199893 (23.11.2017 Gazette 2017/47)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **18.05.2016  JP 2016099248**

(71) Applicant: **Soken Chemical & Engineering Co.,
Ltd.
Toshima-ku
Tokyo 171-8531 (JP)**

(72) Inventors:
• **MIYAZAWA, Yukihiro
Sayama-shi
Saitama 350-1320 (JP)**
• **TAKEDA, Ai
Sayama-shi
Saitama 350-1320 (JP)**

(74) Representative: **Gulde & Partner
Patent- und Rechtsanwaltskanzlei mbB
Wallstraße 58/59
10179 Berlin (DE)**

(54) **PHOTOCURABLE RESIN COMPOSITION, RESIN LAYER OF SAME, AND MOLD FOR IMPRINT**

(57)  A photo-curable resin composition is provided that is capable of forming a resin layer having solvent resistance and capable of easily forming a releasing layer on the resin layer. According to the present invention, a photo-curable resin composition comprising a silicone oligomer having an alkoxy group bonded to a silicon atom and a (meth)acrylate compound is provided.

**EP 3 460 828 A1**

## Description

### Technical Field

Several aspects of the present invention relate to a photo-curable resin composition, a resin layer thereof, and an imprint mold.

### Background Art

As a resin-made imprint mold, a resin mold comprising a molding layer composed of an inorganic compound and a releasing layer(a mold-releasing layer) is disclosed (Patent Literature 1) .

### Citation List

### Patent Literature

Patent Literature 1: WO2008/149544

### Summary of Invention

### Technical Problem

However, in order to form the molding layer composed of an inorganic compound in Patent Literature 1, a vapor deposition apparatus is required, and the obtained resin mold becomes expensive, which is disadvantageous.

Therefore, it is necessary to form a molding layer and a releasing layer not depending on the inorganic compound. However, in the concavo-convex pattern formed by the imprinting process, further refinement, uniformity of shape and dimensions are required, and when removing the impurities by washing the concavo-convex pattern formed in imprint processes with an organic solvent, it is required to be a resin layer having high solvent resistance. Further, it is also required to be a resin layer capable of easily forming a releasing layer with high releasability.

The present invention has been made in view of such circumstances and an object of the present invention is to provide a photo-curable resin composition capable of forming a resin layer having solvent resistance and capable of easily forming a releasing layer on the resin layer.

### Solution to Problem

According to the present invention, a photo-curable resin composition comprising a silicone oligomer having an alkoxy group bonded to a silicon atom and a (meth)acrylate compound, is provided.

As a result of investigations on the photo-curable resin composition capable of forming a resin layer having solvent resistance and capable of easily forming a releasing layer on the resin layer by the present inventors, it was found that a silicone oligomer having an alkoxy group bonded to a silicon atom and a (meth)acrylate compound can be contained, and the present invention has been completed.

Hereinafter, various embodiments of the present invention will be exemplified. The embodiments provided hereinafter can be combined with each other.

Preferably, the (meth)acrylate compound includes a trifunctional or higher functional (meth)acrylate compound in a blend ratio of 60 mass% or more.

Preferably, the silicone oligomer has a substituent including a reactive functional group.

According to another aspect of the present invention, a resin layer formed by using the resin composition is provided.

According to another aspect of the present invention, an imprint mold containing the resin layer is provided.

### Description of Embodiments

Hereinafter, the present invention will be described in detail.

The present invention is a photo-curable resin composition comprising a silicone oligomer and a (meth)acrylate compound, wherein the silicone oligomer has an alkoxy group bonded to a silicon atom.

In the present specification, the (meth)acryloyl group means a methacryloyl group and/or an acryloyl group, and the (meth)acrylate means methacrylate and/or acrylate.

<Photo-Curable Resin Composition>

1. Silicone Oligomer

The silicone oligomer contained in the photo-curable resin composition of the present invention has an alkoxy group bonded to a silicon atom.

In the present invention, the silicone oligomer is a dimer or more excluding a monomer, and has a siloxane bond (-Si-O-Si-) as a main chain.

In the present invention, the silicone oligomer has an alkoxy group bonded to a silicon atom. By containing the silicone oligomer having an alkoxy group bonded to a silicon atom, the resin surface forming the resin layer has a reaction site with a releasing treatment agent, and it is possible to form the releasing layer easily and efficiently.

The alkoxy group on the silicon atom is not limited as long as it can react with the releasing treatment agent to form a releasing layer, and examples thereof include an alkoxy group having a linear or branched alkyl group on an oxygen atom bonded to a silicon atom, and the like. Preferably, the alkoxy group on the silicon atom is a methoxy group, an ethoxy group, a propoxy group, an isopropoxy group, a n-butoxy group, a sec-butoxy group, a tert-butoxy group or the like. More preferably, the alkoxy group on the silicon atom is the methoxy group or the ethoxy group, and further more preferably the methoxy group from the viewpoints of reactivity with the releasing treatment agent and synthesis and availability of raw materials.

The silicone oligomer that can be used in the present invention is a dimer or higher oligomer, but the weight average molecular weight of the silicone oligomer is preferably 500 to 5000, more preferably 750 to 2000, further more preferably 900 to 1500. When the weight average molecular weight of the silicone oligomer is 500 or more, it is excellent in solvent resistance, and when the weight average molecular weight of the silicone oligomer is 5000 or less, it is not separated in the resin composition, and the viscosity of the resin composition does not affect the workability.

The viscosity of the silicone oligomer is not particularly limited as long as it does not affect the workability, but the preferable viscosity of the silicone oligomer is, for example, 5 to 100 $mm^2$/s, and more preferably 10 to 50 $mm^2$/s at 25°C.

The silicone oligomer has an alkoxy group bonded to a silicon atom, and on the silicon atom, in addition to the alkoxy group, an organic group such as an alkyl group may be contained as a substituent. From the viewpoint of solvent resistance, it is preferable that have the substituent has a reactive functional group which reacts with the (meth)acrylate compound. Examples of the reactive functional group include a carbon-carbon double bond, a carbon-carbon triple bond, an epoxy group, and a mercapto group. Specifically, a (meth)acryloyl group, a vinyl group or the like is preferable, the (meth)acryloyl group is more preferable, and an acryloyl group is particularly preferable. When the silicone oligomer has the reactive functional group as described above, it forms a covalent bond with the (meth)acrylate compound and further inhibits elution by washing with an organic solvent, so that the solvent resistance is further improved.

When the silicone oligomer has an acryloyl group as the reactive functional group, the equivalent weight of the acryloyl group in the silicone oligomer can be, for example, 50 to 500 g/mol, preferably 100 to 350 g/mol, more preferably 150 to 250 g/mol.

The amount of the silicone oligomer in the resin composition varies depending on the releasing treatment conditions. When the total amount of the silicone oligomer and (meth)acrylate compound in the resin composition is 100 parts by mass, the amount of the silicone oligomer is, for example, 0.1 to 70 parts by mass, preferably 5 to 60 parts by mass, and more preferably 15 to 50 parts by mass. When the amount of the silicone oligomer is 0.1 parts by mass or more, the releasing layer is easily formed by the releasing treatment agent, and when the amount is 70 parts by mass or less, the resin layer has fastness (strength) and even when it is used for imprinting or the like, the fine concavo-convex pattern hardly collapses.

2. (Meth)acrylate Compound

The photo-curable resin composition of the present invention contains the following (meth)acrylate compound as a (meth)acryl-based monomer.

In the present invention, the (meth)acrylate compound can be used as long as it gives sufficient solvent resistance to the resin layer to be formed, and when a polyfunctional (meth)acrylate compound is contained, high solvent resistance can be obtained. In particular, it is preferable to contain a trifunctional or higher functional (meth)acrylate compound.

Among the (meth)acrylate compounds, the blend ratio of the trifunctional or higher functional (meth)acrylate compound is preferably 60 mass% or more, more preferably 80 mass% or more, further preferably 90 mass% or more. When the blend ratio of the trifunctional or higher functional (meth)acrylate compound is 60 mass% or more, a covalent bond can be sufficiently formed with the (meth)acrylate compound and/or silicone oligomer, and elution by washing with an organic solvent can be further suppressed.

The trifunctional or higher functional (meth)acrylate compound is a (meth)acrylate compound having three or more (meth)acryloyl groups, specifically, trifunctional (meth)acrylate compound such as trimethylolpropane tri(meth)acrylate, ethylene oxide modified trimethylolpropane tri(meth)acrylate, pentaerythritol tri(meth)acrylate, ethoxylated isocyanuric acid tri (meth)acrylate, ε-caprolactone modified tris ((meth)acroxyethyl) isocyanurate; and tetrafunctional or higher functional (meth)acrylate compound such as pentaerythritol tetra (meth)acrylate, dipentaerythritol penta (meth)acrylate monopropionate, dipentaerythritol hexa (meth)acrylate, tetramethylolethane tetra (meth)acrylate, oligoester tetra (meth)acrylate.

Among the above (meth)acrylate compounds, ethylene oxide modified trimethylolpropane triacrylate and dipentaerythritol hexaacrylate are preferable.

The bifunctional or lower functional (meth)acrylate compound that can be used together with the trifunctional or higher functional (meth)acrylate compound is a (meth)acrylate compound having one or two (meth)acryloyl groups.

Examples of the bifunctional (meth)acrylate compound having two (meth)acryloyl groups include tripropylene glycol di (meth)acrylate, ethylene oxide modified bisphenol A di (meth)acrylate, 1,4-butanediol di (meth)acrylate, 1,6-hexanediol di (meth)acrylate, 1,9-nonanediol di (meth)acrylate, (poly) ethylene glycol di (meth)acrylate, (poly) propylene glycol di (meth)acrylate, neopentyl glycol di (meth)acrylate, pentaerythritol di (meth)acrylate, trimethylolpropane di (meth)acrylate, and the like.

Examples of the monofunctional (meth)acrylate compound having one (meth)acryloyl group include:

(meth)acrylic alkyl ester having a linear alkyl group, such as methyl (meth)acrylate, ethyl (meth)acrylate, n-propyl (meth)acrylate, n-butyl (meth)acrylate, n-pentyl (meth)acrylate, n-hexyl (meth)acrylate, n-octyl (meth)acrylate, n-nonyl (meth)acrylate, decyl (meth)acrylate, dodecyl (meth)acrylate, and stearyl (meth)acrylate;
(meth)acrylic alkyl ester having a branched alkyl group, such as iso-propyl (meth)acrylate, iso-butyl (meth)acrylate, tert-butyl (meth)acrylate, 2-ethylhexyl (meth)acrylate, and isooctyl (meth)acrylate;
(meth)acrylic alkyl ester having a cyclic alkyl group, such as isobornyl (meth)acrylate and cyclohexyl (meth)acrylate; and
(meth)acrylic ester having an aromatic ring group, such as benzyl (meth)acrylate and phenoxyethyl (meth)acrylate.

The above (meth)acrylate compound may contain a functional group, and examples of the functional group include a hydroxyl group, an acid group, an epoxy group, an amino group, an amide group, a cyano group, and the like. Examples of the (meth)acrylate compound containing a functional group, specifically, include: (meth)acrylic acid ester having an alkoxy groups such as methoxy polyethylene glycol (meth)acrylate, ethoxydiethylene glycol (meth)acrylate, butoxydiethylene glycol acrylate, methoxyethyl acrylate, methoxypropyl (meth)acrylate, Ethoxyethyl acrylate, ethoxypropyl (meth)acrylate and butoxyethyl acrylate;
(meth)acrylic acid ester having an allyl group such as allyl (meth)acrylate; hydroxyl group-containing (meth)acrylate compounds such as 2-hydroxyethyl (meth)acrylate, 2-hydroxypropyl (meth)acrylate, 2-hydroxybutyl (meth)acrylate, N-hydroxymethyl (meth)acrylamide, 2-hydroxyethyl (meth)acryloyl phosphate, 2-(meth)acryloyloxyethyl-2-hydroxypropyl phthalate, 2-hydroxy-3- (meth)acryloyloxypropyl (meth)acrylate, caprolactone modified 2-hydroxyethyl (meth)acrylate, Polyethylene glycol (meth)acrylate, caprolactone modified 2-hydroxyethyl (meth)acrylate; acid group-containing (meth)acrylate compounds such as monocarboxylic acid monomer such as (meth)acrylic acid, crotonic acid, undecylenic acid, cinnamic acid, and dicarboxylic acid such as maleic acid, fumaric acid, itaconic acid and anhydrides thereof; epoxy group-containing (meth)acrylate compounds such as glycidyl (meth)acrylate, 4-hydroxybutyl (meth)acrylate glycidyl ether; (meth)acrylamide, (meth)acrylonitrile, N, N-dimethylaminoethyl (meth)acrylate.

In addition to the (meth)acryl-based monomer, the photo-curable resin composition of the present invention may contain other photopolymerizable monomers as long as the properties of the present invention are not impaired. Examples of other photopolymerizable monomers include styrene-based monomer and vinyl-based monomer.

Here, examples of the styrene-based monomer may include: alkylstyrene, such as styrene, methylstyrene, dimethylstyrene, trimethylstyrene, ethylstyrene, diethylstyrene, triethylstyrene, propylstyrene, butylstyrene, hexylstyrene, heptylstyrene, and octylstyrene; styrene halide, such as fluorostyrene, chlorostyrene, bromostyrene, dibromostyrene, and iodostyrene; nitrostyrene; acetylstyrene; methoxystyrene; and the like.

Examples of the vinyl-based monomer may include: vinylpyridine, vinylpyrrolidone, vinylcarbazole, divinylbenzene, vinyl acetate; conjugated diene monomers, such as butadiene, isoprene, and chloroprene; vinyl halide, such as vinyl chloride and vinyl bromide; vinylidene halide, such as vinylidene chloride; and the like.

In the photo-curable resin composition of the present invention, the content of the another photopolymerizable monomer other than the (meth)acrylate compound, is preferably 0 to 30 parts by mass, more preferably 0 to 10 parts by mass based on 100 parts by mass of the (meth)acryl-based monomer in the photo-curable resin composition. When the content of the photopolymerizable monomer other than the (meth)acrylate compound is in an amount within the above range, it is possible to form a tough and fine structure.

The (meth)acryl-based monomers and the another photopolymerizable monomers may be used alone or in combination.

3. Photoinitiator

The photoinitiator is a component added to promote polymerization of the monomer and is contained, for example, 0.1 parts by mass or more based on 100 parts by mass of the monomer. Although the upper limit of the content of the photoinitiator is not particularly defined, it is, for example, 20 parts by mass based on 100 parts by mass of the monomer. The content of the photoinitiator is specifically, for example, 0.1, 0.5, 1, 2, 3, 4, 5, 6, 7, 8, 9, 10, 15, or 20 parts by mass based on 100 parts by mass of the monomer and may be within a range between any two of the numerical values exemplified here. Although the type of photoinitiator is not particularly limited, an alkylphenon-based photoinitiator and an acylphosphine oxide-based photoinitiator are preferably used in combination.

The alkylphenon-based photoinitiator and the acylphosphine oxide-based photoinitiator are used in combination as the photoinitiator, thereby adequately reducing the polymerization rate to cause the unpolymerized resin composition to enter between the resin shrunk by the polymerization and the master mold during polymerization. It is thus possible to reduce curing shrinkage of the structure obtained by photo curing of the composition of the present invention. In addition, since the resin polymerized later sufficiently forms a crosslinking structure on the surface, it has hardness higher than that of the resin polymerized earlier and thus the surface hardness is considered to be increased.

In the present invention, regarding the amounts of both photoinitiators used in the photo-curable resin composition, the alkylphenon-based photoinitiator is used preferably 0.01 to 20 parts by mass, more preferably 0.1 to 15 parts by mass, and even more preferably 0.5 to 10 parts by mass based on 100 parts by mass of the (meth)acryl-based monomer in the photo-curable resin composition, and the acylphosphine oxide-based photoinitiator is used preferably 0.01 to 20 parts by mass, more preferably 0.1 to 15 parts by mass, and even more preferably 0.5 to 10 parts by mass.

Use of the alkylphenon-based photoinitiator (B1) and the acylphosphine oxide-based photoinitiator (B2) within the above ranges enables control of the amount of generated radicals.

A weight ratio (B1:B2) of the alkylphenon-based photoinitiator (B1) to the acylphosphine oxide-based photoinitiator (B2) is 1:99 to 90:10, preferably 5:95 to 80:20, more preferably 10:90 to 70:30, more preferably 10:90 to 49:51 and most preferably 10:90 to 25:75.

Use of the alkylphenon-based photoinitiator and the acylphosphine oxide-based photoinitiator in the above weight ratio enables formation of a relatively rigid polymer at an appropriate polymerization rate and also enables suppression of yellowing of the obtained polymer.

The alkylphenon-based photoinitiator is preferably a compound not containing nitrogen, more preferably at least one selected from the group consisting of 2,2-dimethoxy-1,2-diphenylethane-1-one,1-hydroxy-cyclohexyl-phenyl-ketone, 2-hydroxy-2-methyl-1-phenyl-propane-1-one, 1-[4-(2-hydroxyethoxy)-phenyl]-2-hydroxy-2-methyl-propane-1-one, and 2-hydroxy-1-{[4-(2-hydroxy-2-methyl-propionyl)-benzil]phenyl}-2-methyl-propane-1-one, and most preferably 1-hydroxy-cyclohexyl-phenyl-ketone.

Commercially available examples of the alkylphenon-based photoinitiator may include IRGACURE 651, IRGACURE 184, IRGACURE 2959, IRGACURE 127, IRGACURE 907, IRGACURE 369 (all produced by BASF SE) and IRGACURE 1173 (produced by Ciba Japan K.K.).

The acylphosphine oxide-based photoinitiator is preferably at least one selected from the group consisting of 2,4,6-trimethylbenzoyl-diphenyl-phosphine oxide and bis(2,4,6-trimethylbenzoyl)-phenylphosphine oxide and most preferably bis(2,4,6-trimethylbenzoyl)-phenylphosphine oxide.

Commercially available examples of the acylphosphine oxide-based photoinitiator may include LUCIRIN TPO and IRGACURE 819 (both produced by BASF SE). 4. Others

The photo-curable resin composition of the present invention may contain components, such as a solvent, a chain transfer agent, an antioxidant, a photosensitizer, a filler, and a leveling agent, without affecting the properties of the photo-curable resin composition in use.

It is possible to manufacture the photo-curable resin composition of the present invention by mixing the above components in a known method.

<Method of Using Photo-Curable Resin Composition>

1. Formation of Resin Layer

The photo-curable resin composition of the present invention can be used for forming various resin films, for example, can be used for forming a resin layer of a structure or the like on which a fine pattern is formed on the surface of a master mold or the like used in light imprint by photocuring. When the resin film is required to have transparency and a resin layer is provided on the substrate, it is preferable that the resin layer is laminated on a substrate having transparency. Hereinafter, the case of using for light imprint, that is, the case of using as a photo-curable resin composition for imprint will be described.

The light imprint includes:

(I-1) a procedure of applying the photo-curable resin composition of the present invention on a substrate;
(II-1) a procedure of causing a master mold with a fine pattern formed on a surface to abut on the photo-curable resin composition on the substrate;
(III) a procedure of curing the photo-curable resin composition by irradiating the photo-curable resin composition between the substrate and the master mold with light; and
(IV) a procedure of peeling the master mold from the cured photo-curable resin composition.

The procedures (I) and (II) may be:

(I-2) a procedure of dropping the photo-curable resin composition of the present invention on a master mold with a fine pattern formed on a surface; and
(II-2) a procedure of covering a surface of the photo-curable resin composition with a substrate. As a result, a structure is manufactured that has a resin layer having a surface with the fine pattern on the surface of the master mold transferred thereto.

Examples of the substrate in the procedures (1-1) and (II-2) may include a resin, glass, silicon, sapphire, gallium nitride, carbon, silicon carbide, and the like. Examples of the resin used for the above substrate may preferably include polyethylene terephthalate, polycarbonate, polyester, methyl polymethacrylate, polystyrene, polyolefin, polyimide, polysulfone, polyethersulfone, polyethylene naphthalate, and the like.

Examples of the form of resin used for the above substrate may include the form of the resin above and the form of a film. These forms are selected depending on the type of imprint.

Examples of the method of applying the photo-curable resin composition of the present invention in the procedure (1-1) on the substrate may include spin coating, spray coating, bar coating, dip coating, die coating, slit coating, and the like.

The amount of applying the photo-curable resin composition of the present invention on the substrate in the procedure (1-1) and the amount of dropping it on the master mold in the procedure (1-2) is preferably $1 \times 10^{-4}$ to $1 \times 10^{-1}$ g/cm$^2$ and more preferably $1 \times 10^{-3}$ to $1 \times 10^{-2}$ g/cm$^2$.

The fine pattern formed in the surface of the master mold in the procedures (II-1) and (1-2) is normally concave and convex and is a pattern repeated on a regular cycle. That is, the pattern is a fine pattern, which preferably has a cycle from 10 nm to 50$\mu$m, a width of convex portion (diameter) from 10nm to 100$\mu$m a height of convex portion from 10nm to 10$\mu$m, more preferably has a cycle from 10 to 300 nm, a width of convex portion (diameter) from 10 to 300 nm, a height of convex portion from 10 to 300 nm, a transfer surface from 1.0 to $1.0 \times 10^6$ mm$^2$, more preferably has a cycle from 10 to 100 nm, a width of convex portion (diameter) from 10 to 100 nm. In the present invention, even if it is an extremely fine pattern, a desired fine pattern can be obtained (the convex portion does not collapse) after imprinting by using a resin composition containing a predetermined compound. It is preferable that the aspect ratio (ratio of height to width) in the convex portion of the fine pattern to be formed is 1.0 or more and the transfer surface is in the range of 1.0 to $1.0 \times 10^6$ mm$^2$.

Examples of the specific concave and convex shape may include a moth eye structure, lines, columns, monoliths, circular cones, polygonal pyramids, and microlense arrays.

In the procedure (II-1), the master mold abuts on the photo-curable resin compositio of the present invention normally at strength from $1.0 \times 10^{-3}$ to 1.0 MPa and normally holds from 1 to 300 seconds.

Examples of the light in the procedure (III) may include active energy rays, such as ultraviolet rays, visible light rays, infrared rays, and electron beams. The condition for light irradiation is normally from 100 to 18,000 mJ/cm$^2$.

In the procedure (IV), an operation to detach the master mold from the cured resin is performed.

By the above light imprint, the photo-curable resin composition of the present invention becomes a structure with the fine pattern of the master mold transferred to the surface.

2. Formation of Releasing Layer

The releasing layer is formed by applying a release agent to the resin layer formed by photocuring the photo-curable resin composition of the present invention and a resin layer having a releasing layer on one side of the resin layer is obtained. When the resin film is required to have transparency and a resin layer is provided on the substrate, it is preferable that a transparent substrate is laminated on the other surface of the resin layer provided with the releasing layer. In light imprint, the releasing layer is formed on a resin layer which is a structure on which a fine pattern is formed. Here, the releasing layer means a layer having releasability from various deposits. The deposit may be dirt, water, an organic solvent, a resin composition, or the like, but when it is formed on an imprint mold, it is a mold release layer.

As a method for forming the releasing layer, a known method can be used. Specifically, there are a method in which a release agent is coated once or a plurality of times in accordance with the properties of the resin layer, and a method in which the structure is immersed in a container containing a release agent.

As the release agent, a known silane coupling agent can be used. For example, it is preferable to use a fluorine-containing silicon compound, a polymerizable unsaturated group-containing silicon compound, a silicon compound having an epoxy structure, an amino group-containing silicon compound, an oligomer type silane coupling agent or the like as long as sufficient releasability can be imparted. Among them, it is preferable to use a fluorine-containing silicon compound having good releasability as a silane coupling agent, and examples of commercially available products include OPTOOL DSX (manufactured by Daikin Industries, Ltd.). The release agent can be used alone, or two or more kinds can be used in combination.

< Structure and Releasing Layer Obtained From Photo-Curable Resin Composition>

1. Physical Properties of Structure

A structure having a resin layer to which a fine pattern of a master mold is transferred on the surface obtained by light imprinting the photo-curable resin composition of the present invention has the following physical properties.

The solvent resistance of the fine pattern of the resin layer formed on the structure is preferably 2% or less, and more preferably 1% or less. The reasons for such solvent resistance is because the silicone contained the photo-curable resin composition of the present invention is an oligomer having a certain molecular weight or more, and when a silicone monomer having a small molecular weight is used, the solvent resistance is inferior. In addition, it also contributes to solvent resistance by containing the trifunctional or higher functional (meth)acrylate compound as (meth)acrylate compounds at a certain ratio or more.

Specific methods of evaluating the solvent resistance are described in the Examples.

2. Physical Properties of Releasing Layer

The structure on which the releasing layer is formed has the following physical properties.

The transferability of the fine pattern of the structure on which the releasing layer is formed is preferably 95% or more, and more preferably 97% or more. The reasons for such transferability is because the resin layer as a structure has an alkoxy group derived from a silicone oligomer on a silicon atom and the alkoxy group becomes a reaction site with a silane coupling agent or the like and a releasing layer is easily formed.

Specific methods of evaluating the transferability are described in the Examples.

3. Application of Structure with Releasing Layer

Although the applications of the structure having the mold release layer formed with the fine pattern formed on the resin layer made of the photo-curable resin composition of the present invention are not particularly limited, the structure can be used as, for example, a water repellent film, a mold for nanoimprinting, or the like.

Examples

Examples and Comparative Examples of the present invention are described below.

Firstly, a fine pattern (Shape: line & space; height of shape: 100 nm; cycle: 100 nm) of a master mold made of nickel was subjected to release treatment with a fluorine-based mold release agent (OPTOOL HD-2100 produced by Daikin Industries, Ltd.).

Then, photo-curable resin composition containing the silicone, the (meth)acrylate compound and the photoinitiator (1 part by mass of IRGACURE184 as an alkylphenone-based photoinitiator and 5 parts by mass of IRGACURE 819 as an acylphosphine oxide-based photoinitiator) shown in Table 1 was dropped on the master mold, and the resin composition was covered with a PET (polyethylene terephthalate) substrate, followed by rolling a roller on the substrate to uniformly extend the resin liquid ($2.5 \times 10^{-3}$ g/cm$^2$). After that, the UV light irradiation was performed in an amount of the integral light of 200 mJ/cm$^2$ by a UV irradiation device (manufactured by Technovision, Inc., model: UVC-408) to cure the resin, followed by releasing the lamination of PET / the cured resin from the master mold to obtain a sample. The sample thus obtained is referred to below as a "structure".

(Evaluation of Solvent Resistance of Resin Layer of Structure)

The structure thus obtained was immersed in an organic solvent (isopropyl alcohol) for three minutes and the shape height of the fine pattern formed on the resin layer of the structure was measured using a scanning probe microscope (manufactured by Hitachi High-Tech Science Corp., trade name: L-trace), and the solvent resistance was calculated according to Equations 1 and 2 below to evaluate based on the following criteria.

$$\text{Solvent Resistance } (\%) = (1 - \text{Rate of Shape Height Reduction}) \times 100$$
$$\text{(Equation 1)}$$

$$\text{Rate of Shape Height Reduction} = \{(\text{Shape Height of Fine Pattern of Structure after Immersion in Organic Solvent})/(\text{Shape Height of Fine Pattern of Structure before Immersion in Organic Solvent})\} \qquad \text{(Equation 2)}$$

A: Less than 1% of solvent resistance
B: 1% or more and less than 2% of solvent resistance
C: 2% or more of solvent resistance

(Evaluation of Strength of Resin Layer of Structure)

The presence or absence of pattern collapse of the structure transferred from the master mold was confirmed by enlarging it 50000 times with a scanning electron microscope.

A: The pattern is not collapsed.
B: Slight deformation is seen.
C: The pattern is collapsed.

After immersed in a fluorine-based mold release agent (OPTOOL HD-2100 manufactured by Daikin Industries, Ltd.) for one minute, the structure was pulled up and left standing at 70 °C and 90% RH for 1 hour. Thereafter, it was washed off with a fluorine-based solvent (Novec 7100 manufactured by 3M Japan Ltd.).
Subsequently, instead of the master mold made of nickel, a structure body having a mold release layer formed on a resin layer was used as a "resin mold" , a photo-curable resin composition containing (meth) the acrylate compound (EO modified trimethylolpropane triacrylate: 70 parts by mass; dipentaerythritol hexaacrylate: 30 parts by mass) and the photoinitiator (1 part by mass of IRGACURE184 as an alkylphenone-based photoinitiator and 5 parts by mass of IRGACURE 819 as an acylphosphine oxide-based photoinitiator) was dropped on the resin mold and the resin composition was covered with a polyethylene terephthalate (PET) substrate, followed by rolling a roller on the substrate to uniformly extend the resin liquid ($2.5 \times 10^{-3}$ g/cm$^2$). After that, the UV light irradiation was performed in an amount of the integral light of 200 mJ/cm$^2$ by a UV irradiation device (manufactured by Technovision, Inc., model: UVC-408) to cure the resin, followed by releasing the lamination of PET / the cured resin from the resin mold.

(Evaluation of Transferability of Resin Mold)

The degree of resin sticking to the resin mold after imprinting was visually confirmed.

A: No resin sticking
B: Slight resin sticking
C: Resin sticking

[Table 1]

| Table 1 | | Examples | | | | | | | | | Comparative Examples | |
|---|---|---|---|---|---|---|---|---|---|---|---|---|
| | | 1 | 2 | 3 | 4 | 5 | 6 | 7 | 8 | 9 | 1 | 2 |
| Silicone [Part s by mass] | KR-513 | 1 | 5 | 10 | 20 | 30 | 50 | 70 | | 20 | | |
| | KR-500 | | | | | | | | 20 | | | |
| | X-22-2445 | | | | | | | | | | 20 | |
| | KRM-5103 | | | | | | | | | | | 20 |
| (Methyl acrylate compound [Parts by mass] | FO Modified TMPTA | 60 | 65 | 60 | 50 | 40 | 20 | 10 | 50 | 20 | 50 | |
| | OPEIA | 30 | 30 | 30 | 30 | 30 | 30 | 20 | 30 | 30 | 30 | 30 |
| | M-211A | | | | | | | | | 40 | | |
| Solvent Resistance of Resin layer of First Structure | | A | A | A | A | A | A | A | B | B | A | C |
| Strength of Resin layer of First Structure | | A | A | A | A | A | A | B | A | A | - | - |
| Transferability of Resin Mold | | B | A | A | A | A | A | A | A | A | C | A |

Abbreviations in Table 1 denote as follows.
KR-513: silicone oligomer with acryloyl group and methoxy group (produced by Shin-Etsu Chemical Co., Ltd.)
KR-500: silicone oligomer having methyl group and methoxy group (produced by Shin-Etsu Chemical Co., Ltd.)
X-22-2445: modified silicone oil with acryloyl group but without alkoxy group (produced by Shin-Etsu Chemical Co., Ltd.)
KBM-5103: 3-Acryloxypropyl trimethoxysilane (produced by Shin-Etsu Chemical Co., Ltd.) EO modified TMPTA: ethylene oxide modified trimethylolpropane triacrylate
DPHA: dipentaerythritol hexaacrylate
M-211B: bisphenol A ethylene oxide modified diacrylate (produced by Toagosei Co., Ltd.)

(Discussion)

As shown in Examples 1 to 9, when a silicone oligomer with an alkoxy group bonded to a silicon atom was used, good results in both the transferability and the solvent resistance were obtained.

In contrast, as shown in Comparative Example 1, when a silicone oligomer without an alkoxy group bonded to a silicon atom was used, the solvent resistance was good, but the transferability was poor. As shown in Comparative Example 2, when the silicone as the monomer was used, the solvent resistance was poor.

Regarding the solvent resistance, as shown in Examples 1 to 7 and Comparative Example 1, particularly good results were obtained when the silicone oligomer had a reactive functional group (acryloyl group). Regarding the transferability, as shown in Examples 2 to 9, particularly good results were obtained when a large amount of silicone oligomer having an alkoxy group bonded to a silicon atom was contained. As shown in Example 7, when the silicone oligomer was contained more, the strength of the resin layer was inferior.

**Claims**

1. A photo-curable resin composition, comprising a silicone oligomer having an alkoxy group bonded to a silicon atom and a (meth)acrylate compound.

2. The photo-curable resin composition of Claim 1, wherein the (meth)acrylate compound includes a trifunctional or higher functional (meth)acrylate compound in a blend ratio of 60 mass% or more.

3. The photo-curable resin composition of Claim 1 or 2, wherein the silicone oligomer has a substituent including a reactive functional group.

4. A resin layer formed by using the resin composition of any one of Claims 1 to 3.

5. An imprint mold containing the resin layer of Claim 4.

## INTERNATIONAL SEARCH REPORT

| International application No. |
|---|
| PCT/JP2017/018137 |

**A.  CLASSIFICATION OF SUBJECT MATTER**

*H01L21/027*(2006.01)i, *B29C33/38*(2006.01)i, *B29C59/04*(2006.01)i, *C08F2/44*(2006.01)i, *C08F220/18*(2006.01)i, *C08F290/06*(2006.01)i

According to International Patent Classification (IPC) or to both national classification and IPC

**B.  FIELDS SEARCHED**

Minimum documentation searched (classification system followed by classification symbols)
H01L21/027, H01L21/30, B29C29/00-59/06, G03F7/004-7/04, G03F7/075-7/115, G03F7/16-7/18

Documentation searched other than minimum documentation to the extent that such documents are included in the fields searched
Jitsuyo Shinan Koho          1922-1996   Jitsuyo Shinan Toroku Koho   1996-2017
Kokai Jitsuyo Shinan Koho    1971-2017   Toroku Jitsuyo Shinan Koho   1994-2017

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| X<br>A | JP 2015-152726 A  (Sanyo Chemical Industries, Ltd.),<br>24 August 2015 (24.08.2015),<br>paragraphs [0009], [0116] to [0120], [0123]; table 1<br>(Family: none) | 1-4<br>5 |
| Y | JP 2013-168522 A  (Sanyo Chemical Industries, Ltd.),<br>29 August 2013 (29.08.2013),<br>paragraphs [0115] to [0122]<br>(Family: none) | 1-5 |

[X]  Further documents are listed in the continuation of Box C.    [ ]  See patent family annex.

| | |
|---|---|
| *       Special categories of cited documents:<br>"A"    document defining the general state of the art which is not considered   to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
|---|---|
| 05 July 2017 (05.07.17) | 01 August 2017 (01.08.17) |

| Name and mailing address of the ISA/<br>Japan Patent Office<br>3-4-3,Kasumigaseki,Chiyoda-ku,<br>Tokyo 100-8915,Japan | Authorized officer<br><br>Telephone No. |
|---|---|

Form PCT/ISA/210 (second sheet) (January 2015)

11

**INTERNATIONAL SEARCH REPORT**

International application No.

PCT/JP2017/018137

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2016-57356 A  (Tokyo University of Science, Autex, Inc.), 21 April 2016 (21.04.2016), paragraph [0043] (Family: none) | 1-5 |
| Y | JP 2013-163354 A  (Asahi Kasei E-materials Corp.), 22 August 2013 (22.08.2013), paragraphs [0146] to [0147] (Family: none) | 1-5 |
| A | JP 2015-157411 A  (Dainippon Printing Co., Ltd.), 03 September 2015 (03.09.2015), paragraphs [0076], [0078], [0080], [0082] (Family: none) | 1-5 |
| A | JP 2016-35046 A  (Samsung SDI Co., Ltd.), 17 March 2016 (17.03.2016), paragraphs [0034] to [0043] & WO 2016/018003 A1     & TW 201610051 A & CN 106550604 A         & KR 10-2016-0016589 A | 1-5 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008149544 A